# EUROPEAN PATENT APPLICATION

(11) **EP 4 538 213 A1**
(43) Date of publication of application: **16.04.2025**
(21) Application number: 24201707.7
(22) Date of filing: 20.09.2024
(51) Int. Cl.: B66B 5/00

(54) **METHOD FOR MONITORING OPERATION STATUS OF FANS FOR MOTOR AND CORRESPONDING SYSTEM**

(30) Priority: 25.09.2023 CN 202311249097
(71) Applicant: Otis Elevator Company, Farmington, Connecticut 06032 (US)
(72) Inventor: Shen, Yuwei, Tianjin, 300457 (CN); Mu, Tao, Tianjin, 300457 (CN); Su, Yanling, Tianjin, 300457 (CN)
(74) Representative: Schmitt-Nilson Schraud Waibel Wohlfrom Patentanwälte Partnerschaft mbB

(57) **Abstract**

The present application provides a system (1) for monitoring an operation status of a cooling fan (12) for a traction motor (2), wherein the cooling fan (12) comprises one or more fans, the system (1) comprising: a current detection unit (14) for detecting a current transmitted from a power supply (10) to the fan (12); a controller (16) for comparing the current detected with a minimum threshold or a maximum threshold, and generating a prompt signal when the current detected is less than the minimum threshold or greater than the maximum threshold; and an output unit (18) for outputting the prompt signal generated. The corresponding method and application system are also provided.

## Description

The present application relates to technologies related to traction motors, in particular to technologies for monitoring an operation status of a cooling fan of a traction motor.

A cooling device, such as a cooling fan provided on a traction motor's heat radiation ribs, is generally arranged on the traction motor to reduce the motor temperature during operation. Malfunction of the cooling fan will directly affect its cooling effect on the motor, thus affecting the operation of the motor. Therefore, it is necessary to monitor the operating status of the cooling fan.

The present application provides a method for monitoring an operation status of a cooling fan for a traction motor, wherein the cooling fan comprises one or more fans. The method may comprise detecting, by a current detection unit, a current transmitted from a power supply to the fan; outputting a prompt signal when the current detected is less than a minimum threshold or greater than a maximum threshold; and wherein, the minimum threshold is set based on an open circuit current of the fan, and the maximum threshold is set based on a short circuit current of the fan.

Particular embodiments further may include at least one, or a plurality of, the following optional features, alone or in combination with each other:

As an example, according to the method, in the case where the cooling fan comprises a plurality of fans, the fans are connected in parallel to the power supply; and detecting the current transmitted from the power supply to the fan by the current detection unit can comprise detecting a total current transmitted from the power supply to the plurality of fans connected in parallel by the current detection unit. Alternatively, a current of each of the plurality of fans can be detected by a current detection unit which is provided for each of the plurality of fans.

As an example, according to the method, detecting, by the current detection unit, the current transmitted from the power supply to the fan, can comprise: detecting, by the current detection unit, the current transmitted from the power supply to the fan after the fan is started for a duration T.

According to another aspect of the present application, a system for monitoring an operation status of a cooling fan for a traction motor is also provided, wherein the cooling fan comprises one or more fans. The cooling system can comprise a current detection unit for detecting a current transmitted from a power supply to the fan; a controller for comparing the current detected with a minimum or maximum threshold, and generating a prompt signal when the current detected is less than the minimum threshold or greater than the maximum threshold; and an output unit for outputting the generated prompt signal.

As an example, according to the system, in the case where the cooling fan comprises a plurality of fans, the fans are connected in parallel to the power supply, and the current detection unit can be used to detect the total current transmitted from the power supply to the plurality of fans connected in parallel.

As an example, according to the system, in the case where the cooling fan comprises a plurality of fans, the fans are connected in parallel to the power supply, and the current detection unit can be used to detect the current of each of the plurality of fans.

As an example, according to the system, the system further comprises a switch unit for controlling the on/off of the current detection unit. As an example, the current detection unit is a current sensor.

As an example, according to the system, the traction motor is a traction motor of an elevator. The controller is configured to obtain a temperature value from a temperature detection unit of the traction motor, and to stop the traction motor from running when the temperature value obtained is greater than a temperature threshold and the current detected is less than the minimum threshold or greater than the maximum threshold.

According to yet another aspect of the present application, a traction motor for an elevator is further provided, which comprises any one of the systems for monitoring an operation status of a cooling fan for a traction motor as described herein.

According to still another aspect of the present application, an application system for elevator maintenance is still further provided, which is configured in an electronic device. The application system can be implemented as one or more program instructions, where when the one or more program instructions are executed by the electronic device, a prompt signal indicating the operation status of the cooling fan of the traction motor of the elevator is received through an communication interface of the electronic terminal, where the prompt signal is a prompt signal output by any one of the systems for monitoring an operation status of a cooling fan of a traction motor as mentioned above, or the prompt signal output when executing any one of the methods described above; and the prompt signal is output from an output unit of the electronic device, where the output unit includes one or both of a display screen and voice.

Particular embodiments further may include at least one, or a plurality of, the optional features specified above, alone or in combination with each other.

The present application can be fully understood by referring to the detailed description of the specific embodiments below in conjunction with the accompanying drawings, where:
FIG. 1 is a block diagram of a system 1 for monitoring an operation status of a cooling fan for a traction motor according to some examples of the present application;
FIG. 2 is a block diagram of a system for monitoring an operation status of a cooling fan for a traction motor according to an example of the present application;
FIG. 3 is a flowchart of a method for monitoring an operating status of a cooling fan for a traction motor according to some examples of the present application.

In order to make the objective, technical solution, and advantages of the embodiments of the present application clearer, the embodiments of the present application will be described in a clear and comprehensive manner below in conjunction with the accompanying drawings. It should be noted that the embodiments described are only part of the embodiments of the technical solution of the present application, not all of them. All other embodiments obtained by those skilled in the art based on the embodiments recorded in the present application without any creative labor fall within the scope of protection of the present application.

The terms "first", "second", etc. in the description, claims, and accompanying drawings of the present application are used to distinguish similar objects, rather than to describe a specific order or sequence thereof. It should be appreciated that the terms used in this way can be interchanged with each other in appropriate cases, so that the embodiments described herein can be implemented in orders other than those illustrated or described in the embodiments herein. In addition, "first" and "second" are only used for descriptive purposes, and cannot be understood as indicating or implying relative importance or implying or indicating the quantity of technical features indicated. Therefore, the features defined with "first" and "second" can explicitly or implicitly include one or more of such features. In the depiction of the embodiments of the present application, unless otherwise stated, "a plurality of" means two or more.

The terms "example", "as an example", or "illustratively", used in the following text mean "used as an example, embodiment, or illustration". Any embodiment depicted as an "example", or "as an example" or "illustratively" need not be interpreted as being superior or better than other embodiments.

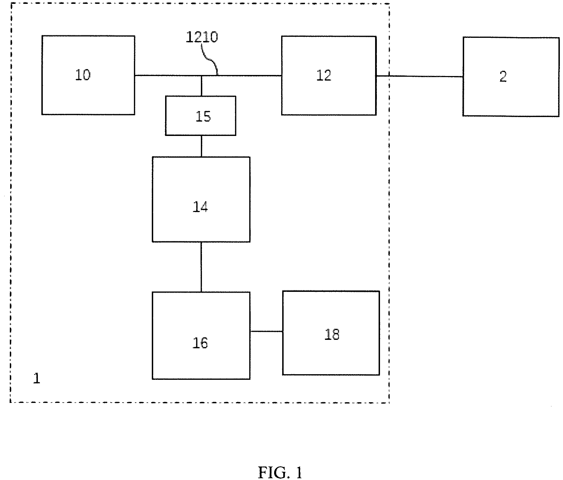

FIG. 1 is a block diagram of a system 1 for monitoring an operation status of a cooling fan for a traction motor according to an example of the present application. As shown in FIG. 1, the system for monitoring an operation status of a cooling fan for a traction motor (hereinafter referred to as a monitoring system 1) comprises a cooling fan 12, a current detection unit 14, a controller 16, and an output unit 18.

The cooling fan 12 can comprise one or more fans for cooling the traction motor 2. Some embodiments of the present application below will be described with a plurality of fans. A power supply 10, which can be battery or mains supply, supplies power to the cooling fan 12. The current detection unit 14 is used to detect the current transmitted from the power supply 10 to the cooling fan 12. The controller 16 can compare the current detected by the current detection unit 14 with the minimum and maximum thresholds, and generates a prompt signal when the current detected is less than the minimum threshold or greater than the maximum threshold. The prompt signal can be output by the output unit 18, so that the situation where the current input to the fan is less than the minimum threshold or greater than the maximum threshold can be known.

Taking a traction motor used in an elevator as an example, the traction motor 2 is usually provided with a thermistor for sensing motor temperature. When the motor temperature is too high, the motor controller will execute appropriate operations to avoid the motor temperature from going too high, which will lead to abnormal operation or damage of the motor. However, this approach mainly detects the temperature of the motor, but does not directly check the operation status of the cooling fan, which makes it difficult to find malfunction of the cooling fan due to its abnormal cooling function in a timely manner.

Referring to FIG. 1, once any of the plurality of fans experiences a short circuit, the current flowing through line 1210 will increase, and once any one of the plurality of fans experiences an open circuit, the current flowing through line 1210 will decrease, where line 1210 is the line for transmitting current from the power supply 10 to the fan 12.

In the monitoring system 1 according to an example of the present application, the controller 16 determines whether the current transmitted from the power supply 10 to the fan 12 is in the range from the minimum to the maximum thresholds based on the pre-set maximum and minimum thresholds. According to the example, the maximum threshold can be determined based on the current transmitted from the power supply 10 to the fan 12 when a short circuit occurs in the fan (hereinafter referred to as short-circuit current). For example, the maximum threshold is slightly less than the short-circuit current. The minimum threshold can be determined based on the current transmitted from the power supply 10 to the fan 12 when an open circuit occurs in the fan (hereinafter referred to as open-circuit current). For example, the minimum threshold is slightly greater than the open-circuit current.

In this way, when the current flowing through the line 1210 detected by the current detection unit 14 is greater than the minimum threshold but less than the maximum threshold, it indicates that the fan is operating normally. If the current detected by the current detection unit 14 is less than the minimum threshold, it indicates that an open circuit may occur in the fan. If the current detected is greater than the maximum threshold, it indicates that a short circuit may occur in the fan. According to an example of the present application, the controller 16 can generate a prompt signal when the current detected by the current detection unit 14 is less than the minimum threshold. The controller 16 can also generate a prompt signal when the current detected by the current detection unit 14 is greater than the maximum threshold. The prompt signal can be output from the output unit 18 of the monitoring system 1, which allows the maintenance personnel to timely learn the operation status of the fan based on the current input to the fan from the power supply, and carry out maintenance and repair work for the cooling system in a timely manner. For a traction motor without the monitoring system 1 according to an example of the present application, when an open circuit or short circuit occurs in the fan, the outside world cannot timely learn these abnormalities of the fan. When the outside world becomes aware of these abnormalities, usually the motor has run abnormally because of its poor cooling function due to fan failure. The abnormal operation of the traction motor may have further caused the elevator and other equipment using the traction motor to stop running. In contrast, by using the monitoring system according to an example of the present application, a prompt signal will be sent when there is a possibility of a short circuit or open circuit in the fan, so that the maintenance personnel can timely inspect and maintain the traction motor, so as to avoid the occurrence of motor shutdown or malfunction due to overheating.

According to some examples of the present application, the current detection unit 14 can be a current sensor. Alternatively, the current detection unit 14 can also be configured as a current detection circuit.

According to some embodiments of the present application, a plurality of fans 12 arranged on the traction motor 2 and the fans are connected in parallel to the power supply 10. The current detection unit 14 detects the total current input from the power supply 10 to the fans 12 connected in parallel. That is, the current detected by the current detection unit 14 is a total of the currents input to all of fans. In some alternative examples, the current detection unit 14 is configured to detect the current of each fan. For example, each of the fans is provided with a current sensor to detect its current. In this alternative example, a maximum threshold and a minimum threshold can be set for the current of each fan. Or, as described earlier in the present application, the maximum threshold and the minimum threshold are set for the current passing through the line 1210, and in this case, the detected current of each fan can be summed up and then compared with the maximum or minimum threshold.

According to some embodiments of the present application, the monitoring system 1 further comprises a switch device 15 for controlling the on/off of the current detection unit 14. For example, the switch device 15 is, for example, a relay, configured to be turned on after the fan 12 is started for a duration T, so that the current detection unit 14 is electrically connected to the fan to detect the current supplied from the power supply 10 to the fan 12. Generally speaking, during the fan startup process, the current is relatively large. By arranging a switch device such as a relay, the current detection unit 14 can be controlled to detect the current after the fan enters the normal operating state from the startup state. This can prevent the current detection unit 14 from generating a prompt signal due to the relatively large starting current when the fan starts. The value of T can be set according to the fan startup time, where a duration T can be, for example, several seconds.

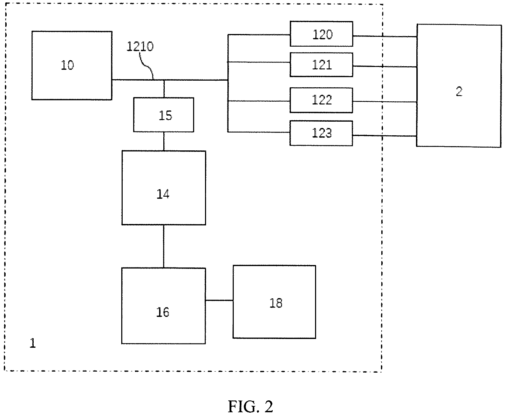

FIG. 2 is a block diagram of the system for monitoring the operation status of the cooling fan for a traction motor according to an example of the present application. The traction motor is a traction motor for an elevator, the current detection unit is a current sensor, and the switch device is a relay. In this example, the cooling fan is arranged on the heat radiation ribs of the traction motor, where the four heat radiation ribs of the traction motor are each provided with a fan.

As shown in FIG. 2, four fans 120, 121, 122, and 123 are provided on the traction motor 2, where these four fans 120, 121, 122, and 123 are connected in parallel to the power supply 10 through the line 1220. The four fans 120, 121, 122, and 123 are respectively arranged on four heat radiation ribs of the traction motor of the elevator. When started, they blow air to the stator of the motor to reduce the temperature. In the example of the present application, the current sensor 14 is connected to the line 1210 through the relay 15 to sense the current on the line 1210 after the relay 15 is turned on, that is, to sense the total current flowing into the four fans 120, 121, 122, and 123.

After the fans 120, 121, 122, and 123 of the monitoring system 1 are started (i.e., after being powered on for a duration T), the relay 15 connects the current sensor 14 to the line 1210, so that the current sensor 14 can sense the current flowing through the line 1210 and obtain the current for detection. The controller 16 compares the current detected by the current sensor 14 with the minimum and maximum thresholds, and generates a prompt signal when the current detected is less than the minimum threshold or greater than the maximum threshold. The output unit 18 sends out the generated prompt signal, so that electronic devices for receiving the prompt signal, such as terminals of the maintenance personnel, computers of the control room, or remote servers, can receive the prompt signal as needed. In this way, the maintenance personnel can be timely informed of any possible abnormalities in the fan and take measures such as inspection, maintenance and repair as early as possible to ensure the normal operation of the fan, thereby avoiding abnormal operation of the traction motor and the elevator due to fan abnormalities.

According to various examples of the present application, the controller 16 is further configured to obtain the temperature of the motor from a temperature sensing unit of the traction motor. The controller 16 compares the motor temperature obtained with the preset temperature threshold. If the motor temperature obtained is greater than the temperature threshold, the controller 16 can send a prompt signal indicating that the motor temperature is high. Further, the controller 16 controls the traction motor to stop running when the motor temperature obtained is greater than the temperature threshold and the current detected by the current sensor 14 is less than the minimum threshold or greater than the maximum threshold. As an example, the temperature threshold is lower than the temperature at which the thermistor operates.

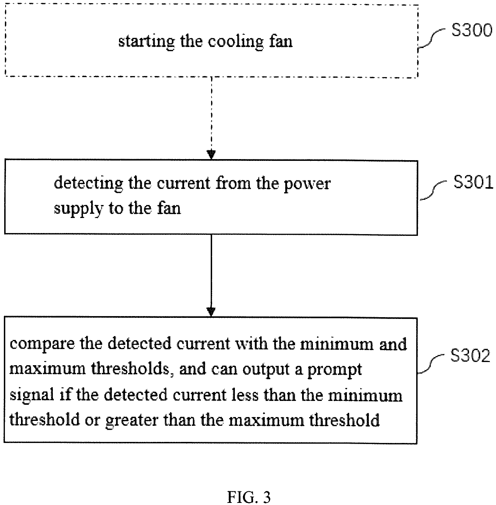

FIG. 3 is a flowchart of a method for monitoring an operation status of a cooling fan for a traction motor according to some examples of the present application. The traction motor can be provided with one or more fans. In step S301, the current detection unit can detect the current supplied from the power supply to the fan. In step S302, when the current detected is less than the minimum threshold or greater than the maximum threshold, a prompt signal is output. The one or more fan can be, for example, arranged on the heat radiation ribs of a traction motor, and the power supply can be a battery or mains supply used to provide power to the fan. The current detection unit can be implemented as a current collection circuit to collect the current input from the power supply to the fan. Alternatively, the current detection unit can also be a current sensor.

In some examples, more than one fans are provided, and these fans are connected in parallel to the power supply. The total current input from the power supply to the fans connected in parallel is detected through a current detection unit. In some alternative or supplementary examples, the current of each fan can be detected.

In further examples of the present application, in the method for monitoring an operation status of a cooling fan for a traction motor according to the examples of the present application, the current of the fan is detected by the current detection unit after the fan is started, as shown in step S300 illustrated in the dashed-line block. For example, within a duration T after the fan is powered on, the current from the power supply to the fan is detected, where the duration T can be greater than or equal to the startup time of the fan.

The method for monitoring an operation status of a cooling fan for a traction motor as exemplified in FIG. 3 can be implemented by any of the systems for monitoring an operation status of a cooling fan for a traction motor described above in conjunction with FIG. 1 or 2. As an example, the current detection unit 14 detects the current input from the power supply 10 to the fan 12 (120, 121, 122, 123) connected in parallel (S301), and the controller 16 compares the current detected with the preset maximum and minimum thresholds (step S302). For example, the controller 16 compares the current detected with the maximum threshold, and generates a prompt signal if the current detected is greater than the maximum threshold. If the current detected is less than the maximum threshold, the current detected is then compared with the minimum threshold, where if the current detected is less than the minimum threshold, a prompt signal is generated. After the prompt signal is generated by the controller 16 based on the comparison results, it is output by the output unit 18 (step S302). According to further examples, the current detection unit 14 is connected to the line 1210 through the relay 15 after the fan is started for a duration T, so as to perform current detection (step S300).

The method for monitoring an operation status of a cooling fan for a traction motor described in conjunction with FIG. 3 may further include: obtaining the temperature of the motor from a temperature sensing unit of the traction motor, comparing the temperature of the motor obtained with a preset temperature threshold, and sending a prompt signal indicating high motor temperature if the motor temperature obtained is greater than the temperature threshold. Further, when the motor temperature obtained is greater than the temperature threshold and the current detected is less than the minimum threshold or greater than the maximum threshold, the traction motor can be controlled to stop running.

In the various examples described in the present application, the controller may be a processor that processes data and controls instructions. Furthermore, the controller can be a processor configured to execute program instructions, which implements the functions of the controller 14 when executing program instructions. These program instructions can be stored in a memory of the controller or in the memory of the traction motor.

The method for monitoring an operation status of a cooling fan for a traction motor according to the examples of the present application can be implemented as a program through programming language, so as to be configured in the memory of the traction motor, which is read and executed by the controller of the traction motor to achieve monitoring of the fan status.

The present application also provides a traction motor for an elevator, where the traction motor includes any one of the systems for monitoring an operation status of a cooling fan for a traction motor as described above. In some cases, one or more cooling fans are arranged on the traction motor, such as on the heat radiation ribs of the traction motor. In this case, the cooling fan can also be served as a component of the traction motor.

The present application further provides an application system for elevator maintenance, which is configured in an electronic device. The application system is implemented by programming language as one or more programs, where when the one or more programs are executed by the electronic device, a prompt signal indicating the operation status of a cooling fan of a traction motor of an elevator is received through a communication interface of the electronic device; and the prompt signal is output from the output unit of the electronic device. As an example, the prompt signal can be a prompt signal output from any example of the system for monitoring an operation status of a cooling fan for a traction motor as described above, or a prompt signal output according to the method for monitoring an operation status of a cooling fan for a traction motor as described above. The prompt signal can be displayed on a display screen of the electronic device and/or output by a voice output unit of the electronic device. As an example, the application system can be implemented as an application for installation by applicable electronic devices, so that the electronic devices installed with it can be used to monitor the operation status of the cooling fan of the traction motor as described herein.

Although specific embodiments of the present application have been shown and described in detail to illustrate the principle of the present application, it should be understood, however, that the present application may be implemented in other ways without departing from the principle, such as combining the features of the various embodiments described herein to obtain new embodiments.

## Claims

1. A method for monitoring an operation status of a cooling fan for a traction motor, wherein the cooling fan comprises one or more fans, the method comprising:
detecting, by a current detection unit, a current transmitted from a power supply to the cooling fan;
outputting a prompt signal when the detected current is less than a minimum threshold or greater than a maximum threshold;
wherein, the minimum threshold is set based on an open circuit current of the fan, and the maximum threshold is set based on a short circuit current of the fan.

2. The method according to claim 1, wherein when the cooling fan comprises a plurality of fans, the fans are configured to be connected in parallel to the power supply; and the detecting, by the current detection unit, the current transmitted from the power supply to the fan, comprising:
detecting, by the current detection unit, a total current transmitted from the power supply to the plurality of fans connected in parallel.

3. The method according to claim 1 or 2, wherein when the cooling fan comprises a plurality of fans, the fans are configured to be connected in parallel to the power supply; and the detecting, by the current detection unit, the current transmitted from the power supply to the fan, comprising:
detecting, by a current detection unit provided for each of the plurality of fans, the current of each fan.

4. The method according to any of claims 1 to 3, wherein the detecting, by the current detection unit, the current transmitted from the power supply to the fan, comprising:
detecting, by the current detection unit, the current transmitted from the power supply to the fan after the fan is started for a duration T.

5. A system for monitoring an operation status of a cooling fan for a traction motor, wherein the cooling fan comprises one or more fans, the system comprising:
a current detection unit for detecting a current transmitted from a power supply to the fan;
a controller for comparing the current detected with a minimum threshold or a maximum threshold, and generating a prompt signal when the detected current is less than the minimum threshold or greater than the maximum threshold; and
an output unit for outputting the prompt generated signal.

6. The system according to claim 5, wherein when the cooling fan comprises a plurality of fans, the fans are connected in parallel to the power supply, and the current detection unit is used to detect a total current transmitted from the power supply to the plurality of fans connected in parallel.

7. The system according claim 5 or 6, wherein when the cooling fan comprises a plurality of fans, the fans are connected in parallel to the power supply, and wherein, the current detection unit is used to detect a current of each of the plurality of fans.

8. The system according to any of claims 5 to 7, wherein the output unit comprises a communication unit.

9. The system according to any of claims 5 to 8, wherein the current detection unit is a current sensor.

10. The system according to any of claims 5 to 9, wherein the system further comprises:
a switch unit for controlling on/off of the current detection unit.

11. The system according to any of claims 5 to 10, wherein, the traction motor is a traction motor of an elevator, and
the controller is configured to obtain a temperature value from a temperature detection unit of the traction motor, and to stop the traction motor from running when the obtained temperature value is greater than a temperature threshold and the current detected is less than the minimum threshold or greater than the maximum threshold.

12. A traction motor for an elevator, wherein the traction motor comprises the system for monitoring an operation status of a cooling fan for a traction motor according to any of claims 5 to 11.

13. An application system for elevator maintenance, configured in an electronic device, wherein the application system is implemented as one or more programs, where when the one or more programs are executed by the electronic device:
a prompt signal indicating an operation status of a cooling fan for a traction motor of the elevator is received through a communication interface of the electronic device;
the prompt signal is output by one or both of a display screen and a voice output of the electronic device;
wherein, the prompt signal is a prompt signal output by the system for monitoring an operation status of a cooling fan for a traction motor according to any of claims 5 to 11, or a prompt signal output by the method according to any of claims 1 to 4.
